(19) Europäisches Patentamt / European Patent Office / Office européen des brevets

(11) **EP 3 458 626 B1**

(12) **EUROPEAN PATENT SPECIFICATION**

(45) Date of publication and mention
of the grant of the patent:
**11.03.2020 Bulletin 2020/11**

(21) Application number: **17720698.4**

(22) Date of filing: **13.04.2017**

(51) Int Cl.:
*C23C 16/448* (2006.01)     *C23C 16/52* (2006.01)

(86) International application number:
**PCT/EP2017/059036**

(87) International publication number:
**WO 2017/198401 (23.11.2017 Gazette 2017/47)**

(54) **SUBLIMATED GAS SUPPLY SYSTEM**

VERSORGUNGSSYSTEM FÜR SUBLIMIERTES GAS

SYSTÈME D'ALIMENTATION EN GAZ SUBLIMÉ

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **20.05.2016 JP 2016101661**

(43) Date of publication of application:
**27.03.2019 Bulletin 2019/13**

(73) Proprietor: **L'Air Liquide Société Anonyme pour
l'Etude et
l'Exploitation des Procédés Georges Claude
75007 Paris (FR)**

(72) Inventors:
• **SHIGAKI, Chika
  300-2358 Ibaraki (JP)**
• **ISHIZUKA, Sayaka
  Tokyo 108-8509 (JP)**
• **KOURA, Terumasa
  Tokyo 108-8509 (JP)**
• **NOZAWA, Fumikazu
  Tokyo 108-8509 (JP)**

(74) Representative: **Grout de Beaufort,
François-Xavier
L'Air Liquide
Direction Propriété Intellectuelle
75, quai d'Orsay
75321 Paris Cedex 07 (FR)**

(56) References cited:
US-A1- 2004 159 005     US-A1- 2004 165 870
US-A1- 2005 019 026     US-A1- 2010 236 480
US-A1- 2011 158 826

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

The present invention relates to a sublimated gas supply system for supplying a sublimated gas of a solid material to a post process(for example, a film forming process).

In order to manufacture microelectronics devices such as semiconductor integrated devices and liquid crystal panels, it is necessary to form a film of various materials on a substrate. Further, in recent years, dry coating has been performed on various members to improve characteristics such as strength of the corresponding member. A PVD (physical vapor deposition) method, a CVD (chemical vapor deposition) method, an ALD (atomic layer deposition) method, etc. have been widely known as the film forming method or the coating method.

In order to respond to sever requirements for a film in accordance with the rapid progress of semiconductor industry, the vapor pressure of a precursor used for forming a film tends to be decreased.

Examples of the precursor used for forming a film include organic metal compounds and inorganic compounds of aluminum, barium, bismuth, chromium, cobalt, copper, gold, hafnium, indium, iridium, iron, lanthanum, lead, magnesium, molybdenum, nickel, niobium, platinum, ruthenium, silver, strontium, tantalum, titanium, tungsten, yttrium, and zirconium. As a precursor for dry coating, an inorganic metal compound is generally used so as to form a carbon-free film.

Because these materials have a low vapor pressure, when these materials are solid materials, it is necessary to sublimate the solid materials to be supplied in introducing the solid materials into a film forming chamber.

With a conventional method, a solid material that is set in a tray inside a container is heated, and a carrier gas is brought into contact with the solid material itself while saturated vapor is generated to supply the carrier gas containing a solid material component (sublimated gas).

However, with the conventional method, the amount of the sublimated gas changes when the remaining amount of the solid material changes, resulting in a change of the concentration of the sublimated gas in the gas supplied in a post process. Therefore, it is sometimes difficult to supply sublimated gas with a stable concentration. Sublimated gas supply systems are known from US2011/0158826 and US2004/0159005.

Objects of the present invention are to provide a sublimated gas supply system and a sublimated gas supply method capable of stabilizing the concentration of a sublimated gas of a solid material to be supplied and continuously supplying a sublimated gas with a stable concentration.

A sublimated gas supply system according to the invention includes:

- a container for storing a solid material;
- a container heating unit for heating the container so that a sublimated gas of the solid material is produced;
- a container pressure gauge for measuring a pressure inside the container;
- a first vacuum container configured so that the sublimated gas is introduced from the container in a state where a pressure of the sublimated gas is in a prescribed negative pressure range (in a vacuum state or a state of a prescribed negative pressure) when the pressure measured with the container pressure gauge is a saturated vapor pressure of the sublimated gas (or when the pressure of the sublimated gas inside the container is a prescribed value or more);
- a first pressure gauge for measuring a pressure inside the first vacuum container;
- a second vacuum container configured so that the sublimated gas is introduced from the container in a state where the pressure of the sublimated gas is in a prescribed negative pressure range (in a vacuum state or a state of a prescribed negative pressure) when the pressure measured with the container pressure gauge is a saturated vapor pressure of the sublimated gas (or when the pressure of the sublimated gas inside the container is a prescribed value or more);
- a second pressure gauge for measuring a pressure inside the second vacuum container;
- a sublimated gas lead-out line for leading out saturated vapor of the sublimated gas from the container to the first vacuum container or the second vacuum container in a switchable manner;
- a dilution gas line for introducing dilution gas into the first vacuum container or the second vacuum container in a switchable manner;
- a flow amount control unit for controlling a flow amount of the dilution gas so that a concentration of the sublimated gas in the dilution gas inside the first vacuum container is controlled to be a prescribed concentration based on the pressure inside the first vacuum container when the sublimated gas is introduced into the first vacuum container, and for controlling a flow amount of the dilution gas so that a concentration of the sublimated gas in the dilution gas inside the second vacuum container is controlled to be a prescribed concentration based on the pressure inside the second vacuum container when the sublimated gas is introduced into the second vacuum container;
- a lead-out line for leading out the sublimated gas from the first vacuum container or the second vacuum container into the post process when the concentration of the sublimated gas in the dilution gas reaches the prescribed concentration in a switchable manner; and
- a vacuum pump line that comprises a vacuum pump and makes the vacuum containers be in a vacuum state in a switchable manner.

According to this configuration, the sublimated gas can be fed from the container into the first vacuum container or the second vacuum container alternatively with two vacuum containers to one container corresponding to request of the post process.

The dilution gas can be fed into the first and second vacuum containers with a single flow amount control unit to adjust the concentration of the sublimated gas inside the first and second vacuum containers.

Further, the first and second vacuum containers can be made in a vacuum state with a single vacuum pump.

In the invention, the sublimated gas supply system may include a gas heating unit (such as a heat exchanger) that is arranged in the dilution gas line and controls a temperature of the dilution gas.

According to this configuration, the temperature of the dilution gas can be controlled to prevent or suppress decreases of the temperature of the vacuum container and the temperature of the sublimated gas inside the vacuum container, and therefore the precipitation of the sublimated solid material can be effectively prevented, and the concentration of the sublimated gas can be stabilized. The gas heating unit preferably controls the temperature of the dilution gas to be the same as the temperature of the sublimated gas.

In the invention, the temperatures of the devices configuring the system (such as vacuum containers and piping where the sublimated gas moves) may be controlled. Accordingly, the precipitation of the solid material due to a decrease of the temperature of the sublimated gas can be effectively prevented, and the concentration of the sublimated gas can be stabilized.

In the invention, the sublimated gas supply system may include:

- a sublimated gas concentration calculation unit for calculating the concentration of the sublimated gas in the dilution gas inside the vacuum container from the pressure inside the vacuum container measured from the pressure gauge; and
- a monitor unit for monitoring the concentration of the sublimated gas calculated in the sublimated gas concentration calculation unit.

As another embodiment, the sublimated gas supply system may include a monitor unit for monitoring the concentration of the sublimated gas in the dilution gas detected by a concentration measurement unit (such as a thermal conductivity detector (TCD)) arranged in the lead-out line.

In the invention, the sublimated gas supply system may include:

- a temperature indicator controller (TIC) for controlling a temperature of the container heating unit; and
- a flowmeter that is arranged in the lead-out line and controls a flow amount of the sublimated gas.

In the invention, where the container is one and the vacuum containers are two, the flow amount control step may be completed in one vacuum container before the lead-out step is completed in the other vacuum container.

The sublimated gas supply method may include a gas heating step of controlling a temperature of the dilution gas.

The sublimated gas supply method may include:

- a concentration calculation step of calculating the concentration of the sublimated gas in the dilution gas inside the vacuum container from the pressure inside the vacuum container; and
- a monitor step of monitoring the concentration of the sublimated gas calculated in the concentration calculation step.

The sublimated gas supply method may include a monitor step of monitoring the concentration of the sublimated gas in the dilution gas detected by a concentration measurement unit (such as a thermal conductivity detector (TCD)) arranged in the lead-out line for leading out the sublimated gas from the vacuum container to the post process.

Fig. 1 illustrates an explanatory diagram showing an outline of a sublimated gas supply system; and
Fig. 2 illustrates an explanatory diagram showing an outline of a sublimated gas supply system according to the invention.

Several embodiments of the present invention will be explained below. The embodiments explained below are to explain one example of the present invention. The present invention is not limited to the following embodiments at all and includes various types of modifications carried out within a scope where the gist of the present invention is not changed. All of the configurations explained below are not necessarily essential configurations of the present invention.

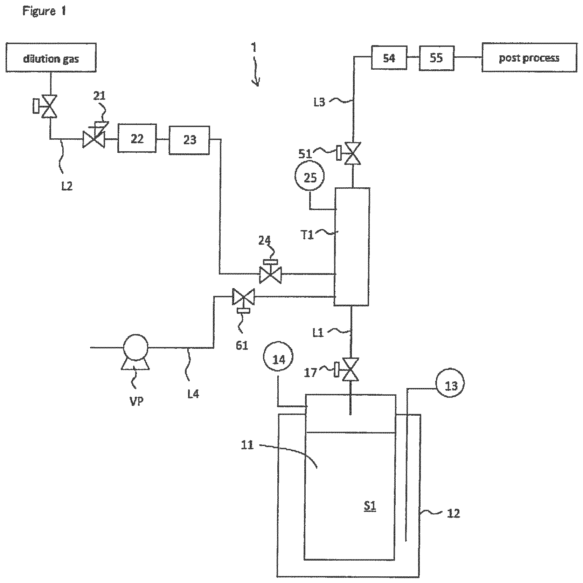

Fig. 1 illustrates an outline of a sublimated gas supply system 1. The sublimated gas supply system is configured with one vacuum container per container.

A solid material S1 is stored in a container 11. The container 11 includes a single or a plurality of trays, which may be a tray type container in which the solid material S1 is placed on a tray or may be a tray-less container in which the solid material S1 is placed as it is inside the container without a tray.

A heater 12 (corresponding to a container heating unit) directly heats the container 11 to produce a sublimated gas of the solid material S1.

As the container heating unit, instead of the heater 12, an oven type container heating unit may be used in heating the container 11 placed in an oven. A heater temperature regulator 13 measures a temperature of the heater 12 and controls the heater temperature. Agate valve 17 is closed to seal the container 11, and the container 11 is heated to generate a sublimated gas. A container pressure gauge 14 measures a pressure inside the container 11.

The sublimated gas is introduced from the container 11 into a vacuum container T1. Before the sublimated gas is introduced, the vacuum container T1 is kept in a vacuum state (substantially vacuum state). A first pressure gauge 25 measures a pressure inside the vacuum container T1. A vacuum pump VP is connected to the vacuum container T1 through a gate valve 61. The gate valve 61 is opened to operate the vacuum pump VP, and the vacuum container T1 is made to be in a vacuum state. At this time, whether or not the pressure inside the vacuum container T1 reaches a vacuum state may be determined from the value measured with the first pressure gauge 25. The vacuum pump VP is operated only when a line L4 is opened, and all of gate valves (17, 24, 51) of other lines (L1, L2, L3) connected to the vacuum container T1 are closed.

When the pressure measured with the container pressure gauge 14 is the saturated vapor pressure of the sublimated gas, the gate valve 17 is opened while the gate valves (24, 51, 61) of the other lines (L2, L3, L4) connected to the vacuum container T1 are closed to introduce the sublimated gas from the container 11 into the vacuum container T1 in a vacuum state. When the pressure value of the first pressure gauge 25 reaches a constant pressure, it is determined that the transfer of the saturated vapor of the sublimated gas is completed, and the gate valve 17 may be closed. When the pressure value of the container pressure gauge 14 reaches a prescribed pressure or less, it is determined that the transfer of the saturated vapor of the sublimated gas is completed, and the gate valve 17 may be closed. Even while the sublimated gas is moved or even after the gate valve 17 is closed, the container 11 is or may be heated with the heater 12, and the sublimated gas is produced inside the container 11.

A dilution gas line L2 that introduces a dilution gas is connected to the vacuum container T1. An inert gas is used as the dilution gas. For example, an inert gas such as nitrogen gas or a noble gas such as argon gas may be used as the dilution gas. Hydrogen gas having good thermal conductivity may be also used.

For example, a pressure control valve 21, a mass flow controller 22, a heat exchanger 23, and the gate valve 24 are arranged in the dilution gas line L2. The pressure control valve 21 has a function of making the pressure inside the container 11 be constant. The mass flow controller 22 measures a flow amount of the dilution gas and controls the flow amount. The mass flow controller 22 may control the flow amount of the dilution gas based on the pressure measured with the first pressure gauge 25 or the concentration of the sublimated gas inside the first vacuum container calculated in a sublimated gas concentration calculation unit. The heat exchanger 23 (corresponding to a gas heating unit) heats the dilution gas so that the temperature of the dilution gas becomes a prescribed temperature.

The sublimated gas inside the vacuum container T1 is in a saturated vapor state. The concentration of the sublimated gas is adjusted in the vacuum container T1 so as to be the concentration of the sublimated gas desired in the post process. Specifically, the gate valve 24 is opened while the gate valves of the other lines (L1, L3, L4) connected to the vacuum container T1 are closed. The dilution gas is fed into the vacuum container T1 while controlling the flow amount of the dilution gas with the mass flow controller 22.

The sublimated gas concentration calculation unit (not shown) calculates a concentration of a sublimated gas in the dilution gas inside the vacuum container T1 based on the pressure measured with the first pressure gauge 25. For example, the concentration of the sublimated gas may be obtained from a correlation between the concentration and the pressure set in advance corresponding each solid material. A monitor unit (not shown) has a function of monitoring the concentration of the sublimated gas calculated by the sublimated gas concentration calculation unit, and the monitor unit may send the data to external devices or display the data on a monitor. Once the concentration of the sublimated gas reaches a prescribed concentration, feeding of the dilution gas may be stopped, or once a pressure measured with a first pressure gauge 25 reaches a prescribed pressure, feeding of the dilution gas may be stopped. The concentration of the sublimated gas may be converted from the "prescribed pressure". The above stopping of the feeding of the dilution gas is performed by closing the gate valve 24.

The concentration of the sublimated gas may be calculated as follows.

If P1 represents the pressure of the vacuum container T1 measured with the first pressure gauge 25 when the sublimated gas is introduced and P2 represents the pressure of the vacuum container T1 measured with the first pressure gauge 25 after the dilution gas is introduced, the concentration of the sublimated gas is obtained from the following formula:

$$\text{Concentration of sublimated gas [Vol\%]} = 100 \times (P1/P2).$$

The dilution gas may be introduced into the vacuum container T1 every time the sublimated gas is introduced from the container 11, after a prescribed number of times of the introduction of the sublimated gas, or after the sublimated gas is fed from the container 11 until the pressure inside the vacuum container T1 exceeds a prescribed pressure.

A lead-out line L3 is provided for leading out the sublimated gas from the vacuum container T1 to the post process. When the concentration of the sublimated gas in the dilution gas reaches a prescribed concentration, the sublimated gas is fed from the vacuum container T1 into the post process through the lead-out line L3. The gate valve 51 is opened while the gate valves of the other lines (L1, L2, L3) connected to the vacuum container T1 are closed. A mass flow meter 55 (corresponding to a flow meter) is arranged in the lead-out line L3 and controls the flow amount of the sublimated gas. A thermal conductivity detector 54 is arranged in the lead-out line L3. The system may have a configuration in which the thermal conductivity detector 54 detects the concentration of the sublimated gas in the dilution gas and the monitor unit (not shown) monitors the concentration of the sublimated gas.

After the sublimated gas is fed from the vacuum container T1, the gate valve 51 of the lead-out line L3 is closed. When the pressure measured with the first pressure gage 25 becomes a prescribed pressure or less, it may be determined that the feeding of the sublimated gas is completed. In order to make the vacuum container T1 be in a vacuum state, the gate valve 61 is opened while the gate valves of the other lines (L1, L2, L3) connected to the vacuum container T1 are closed, and the vacuum pump VP is operated. The vacuum container T1 is made to be in a vacuum state, and in the same as above, the processing is repeated of moving the sublimated gas inside the container 11 into the vacuum container T1.

Based on the pressures measured with the pressure gauges such as the container pressure gauge and the first pressure gauge, various types of control such as the opening and closing control of each gate valve, the determination whether or not the sublimated gas has a saturated vapor pressure, the determination of the timing for introducing the dilution gas, and the temperature control of the heat exchanger 23 (temperature control of the dilution gas) may be performed by a main control unit (not shown) or a control module assigned for each type of control.

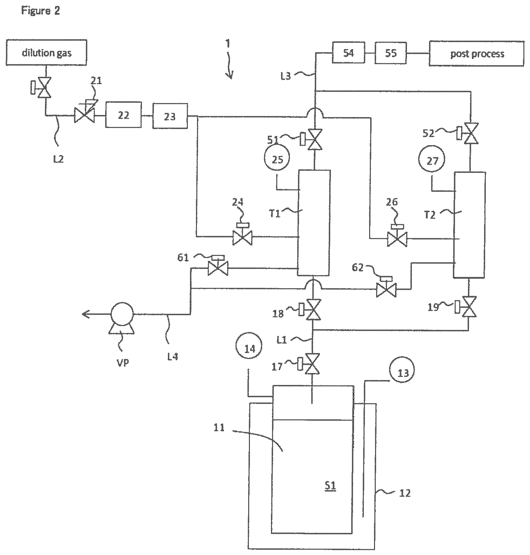

As shown in Fig. 2, the sublimated gas supply system of the invention is configured with two vacuum containers per container. Because the components denoted by the same reference signs have the same configurations as previously described, their explanations are omitted or briefly explained. Before the leading-out of the sublimated gas from the first vacuum container T1 to the post process is completed, the sublimated gas is fed from the container 11 into a second vacuum container T2, and the dilution gas is fed to adjust the concentration of the sublimated gas. After the adjustment of the concentration of the sublimated gas is completed and the feeding of the sublimated gas from the first vacuum container T1 into the post process is finished, the opening and closing of the gate valves is controlled to feed the sublimated gas from the second vacuum container T2 into the post process. On the other hand, before the leading out of the sublimated gas from the second vacuum container T2 to the post process is completed, the sublimated gas is fed from the container 11 into the first vacuum container T1, and the dilution gas is fed to adjust the concentration of the sublimated gas. After the adjustment of the concentration of the sublimated gas is completed and the feeding of the sublimated gas from the second vacuum container T2 into the post process is finished, the opening and closing of the gate valves is controlled to feed the sublimated gas from the first vacuum container T1 into the post process. Because this sublimated gas supply system has two vacuum containers to alternatively adjust the concentration of the sublimated gas with the dilution gas, the sublimated gas can be continuously supplied.

As described above, because the two vacuum containers are alternatively used, a sublimated gas lead-out line L1 has two sublines, and one gate valve (18, 19) is arranged in each of the two sublines.

Further, the dilution gas line L2 for introducing the dilution gas into the first and second vacuum containers T1 and T2 has two sublines, and one gate valve (24, 26) is arranged in each of the two sublines. The lead-out line L3 for sending the sublimated gas from the vacuum container to the post process has two sublines, and one gate valve (51, 52) is arranged in each of the two sublines.

Before the leading out of the sublimated gas whose concentration is adjusted from the first vacuum container T1 to the post process is completed, the following processing is performed in the second vacuum container T2.

When the pressure measured with the container pressure gauge 14 is the saturated vapor pressure of the sublimated gas, the gate valves 17 and 19 are opened while the gate valves (26, 52, 62) of the other lines (L2, L3, L4) connected to the second vacuum container T2 and the gate valve 18 are closed to introduce the sublimated gas from the container 11 into the second vacuum container T2 in a vacuum state. Next, the concentration of the sublimated gas is adjusted in the second vacuum container T2 so as to be a desired concentration in the post process. The gate valve 26 is opened while the gate valves (19, 52, 62) of the other lines (L1, L3, L4) connected to the second vacuum container T2 and the gate valve 24 are closed. The dilution gas is fed into the second vacuum container T2 while controlling the flow amount of the dilution gas with the mass flow controller 22.

The sublimated gas concentration calculation unit (not shown) calculates a concentration of a sublimated gas in the dilution gas inside the second vacuum container T2 based on the pressure measured with the second pressure gauge 27. A monitor unit (not shown) has a function of monitoring the concentration of the sublimated gas calculated by the sublimated gas concentration calculation unit, and the monitor unit may send the data to external devices or display the data on a monitor.

The monitor unit (not shown) may have a configuration of monitoring the concentration of the sublimated gas detected by the thermal conductivity detector 54. Once the concentration of the sublimated gas reaches a prescribed concentration, feeding of the dilution gas may be stopped, or once a pressure measured with the second pressure gauge 27 reaches a prescribed pressure, feeding of the dilution gas may be stopped. The concentration of the sublimated gas may be converted from the "prescribed pressure". The above stopping of the feeding of the dilution gas is performed by closing the gate valve 26.

The dilution gas may be introduced into the second vacuum container T2 every time the sublimated gas is introduced from the container 11, after a prescribed number of times of the introduction of the sublimated gas, or after the sublimated gas is fed from the container 11 until the pressure inside the second vacuum container T2 exceeds a prescribed pressure.

When the processing of feeding the sublimated gas into the post process is completed in the first vacuum container T1, the gate valve 51 of the lead-out line L3 is closed, and the gate valve 52 is opened. Accordingly, the sublimated gas whose concentration is adjusted can be fed from the second vacuum container T2 into the post process through the lead-out line L3.

Before the leading out of the sublimated gas whose concentration is adjusted from the second vacuum container T2 to the post process is completed, the following processing is performed in the first vacuum container T1. The gate valve 51 is closed, and the gate valve 61 is opened to make the first vacuum container T1 be in a vacuum state using the vacuum pump VP.

When the pressure measured with the container pressure gauge 14 is the saturated vapor pressure of the sublimated gas, the gate valves 17 and 18 are opened while the gate valves (24, 51, 61) of the other lines (L2, L3, L4) connected to the first vacuum container T1 and the gate valve 19 are closed to introduce the sublimated gas from the container 11 into the first vacuum container T1 in a vacuum state. Next, the concentration of the sublimated gas is adjusted in the first vacuum container T1 so as to be a concentration desired in the post process. The gate valve 24 is opened while the gate valves (18, 51, 61) of the other lines (L1, L3, and L4) connected to the first vacuum container T1 and the gate valve 26 are closed. The dilution gas is fed into the first vacuum container T1 while controlling the flow amount of the dilution gas with the mass flow controller 22.

The sublimated gas concentration calculation unit (not shown) calculates the concentration of the sublimated gas in the dilution gas inside the first vacuum container T1 based on the pressure measured with the first pressure gauge 25. The monitor unit (not shown) has a function of monitoring the concentration of the sublimated gas calculated by the sublimated gas concentration calculation unit, and the monitor unit may send the data to external devices or display the data on a monitor. The monitor unit (not shown) may have a configuration of monitoring the concentration of the sublimated gas detected by the thermal conductivity detector 54.

Once the concentration of the sublimated gas reaches a prescribed concentration, feeding of the dilution gas may be stopped, or once the pressure measured by the first pressure gauge 25 reaches a prescribed pressure, feeding of the dilution gas may be stopped. The concentration of the sublimated gas may be converted from the "prescribed pressure". The above stopping of the feeding of the dilution gas is performed by closing the gate valve 24.

The dilution gas may be introduced into the first vacuum container T1 every time the sublimated gas is introduced from the container 11, after a prescribed number of times of the introduction of the sublimated gas, or after the sublimated gas is fed from the container 11 until the pressure inside the first vacuum container T1 exceeds a prescribed pressure.

When the processing of feeding the sublimated gas to the post process is completed in the second vacuum container T2, the gate valve 52 of the lead-out line L3 is closed, and the gate valve 51 is opened. Accordingly, the sublimated gas whose concentration is adjusted can be fed from the first vacuum container T1 into the post process through the lead-out line L3. Then, the gate valve 52 is closed, and the gate valve 62 is opened to make the second vacuum container T2 be in a vacuum state using the vacuum pump VP. The above processing is repeated.

Accordingly, the system can respond to the requirements of the post process, the characteristics of the solid material, and the miniaturization of the container.

The sublimated gas supply method for supplying a sublimated gas produced from a solid material to a post process includes:

- a container heating step of heating a container so that the sublimated gas of the solid material stored in the container is produced;
- a container pressure measurement step of measuring a pressure inside the container;
- a buffer step of introducing the sublimated gas from the container into a vacuum container that is in a state of a prescribed negative pressure range (in a vacuum state or a state of a prescribed negative pressure) when the pressure measured in the container pressure measurement step is a saturated vapor pressure of the sublimated gas (or when the pressure of the sublimated gas inside the container is a prescribed value or more);
- a flow amount control step of controlling a flow amount of the dilution gas so that a concentration of the sublimated gas in the dilution gas inside the vacuum container is controlled to be a prescribed concentration based on the pressure inside the vacuum container when the sublimated gas is introduced into the vacuum container;

- a lead-out step of leading out the sublimated gas from the vacuum container into the post process when the concentration of the sublimated gas in the dilution gas reaches the prescribed concentration; and
- a vacuum step of making the vacuum container be in a vacuum state.

In the case where the container is one and the vacuum containers are two, the flow amount control step is completed in one vacuum container before the lead-out step is completed in the other vacuum container. The sublimated gas supply method may include a gas heating step of controlling a temperature of the dilution gas. Further, the sublimated gas supply method may include a concentration calculation step of calculating the concentration of the sublimated gas in the dilution gas inside the vacuum container from the pressure inside the vacuum container; and a monitor step of monitoring the concentration of the sublimated gas calculated in the concentration calculation step. The sublimated gas supply method may include a monitor step of monitoring the concentration of the sublimated gas in the dilution gas detected by a concentration measurement unit (such as a thermal conductivity detector (TCD)) arranged in the lead-out line for leading out the sublimated gas from the vacuum container to the post process.

In the above-described embodiments, the sublimated gas having a saturated vapor pressure is fed from the container into the vacuum container. However, the invention is not limited thereto, and the sublimated gas may be fed from the container into the vacuum container when the pressure of the sublimated gas inside the container is a saturated vapor pressure or a prescribed pressure or more.

In the above-described embodiments, the sublimated gas is fed into the vacuum container under a vacuum state. However, the invention is not limited thereto, and the invention may have a configuration in which the sublimated gas is introduced under a substantial vacuum state or a state in which the inner pressure is a prescribed negative pressure.

The flow amount control unit (mass flow controller) has a configuration in which the flow amount of the dilution gas is controlled so that the concentration of the sublimated gas in the dilution gas inside the vacuum container is controlled to be a prescribed concentration based on the pressure inside the vacuum container. However, the invention is not limited thereto, and the flow amount of the dilution gas may be controlled so that the concentration of the sublimated gas in the dilution gas inside the vacuum container is controlled to be a prescribed concentration based on the initial pressure before the sublimated gas is introduced into the vacuum container and the pressure inside the vacuum container. The flow amount may be controlled based on the inner pressure (initial pressure) of the vacuum container before the sublimated gas is introduced and the pressure fluctuation.

## Claims

1. A sublimated gas supply system for supplying a sublimated gas produced from a solid material to a post process, the system comprising:

   - a container (11) that stores a solid material (S1);
   - a container heating unit (12) that heats the container so that the sublimated gas of the solid material is produced;
   - a container pressure gauge (14) that measures a pressure inside the container;
   - a first vacuum container (T1) configured so that the sublimated gas is introduced from the container in a state where a pressure of the sublimated gas is in a prescribed negative pressure range when the pressure measured with the container pressure gauge is a saturated vapor pressure of the sublimated gas;
   - a first pressure gauge (25) that measures a pressure inside the first vacuum container;
   - a second vacuum container (T2) configured so that the sublimated gas is introduced from the container in a state where a pressure of the sublimated gas is in a prescribed negative pressure range when the pressure measured with the container pressure gauge is a saturated vapor pressure of the sublimated gas;
   - a second pressure gauge (27) that measures a pressure inside the second vacuum container;
   - a sublimated gas lead-out line (L1) that leads out the sublimated gas from the container to the first vacuum container or the second vacuum container in a switchable manner;
   - a dilution gas line (L2) that introduces dilution gas into the first vacuum container or the second vacuum container in a switchable manner;
   - a flow amount control unit (22) that controls a flow amount of the dilution gas so that a concentration of the sublimated gas in the dilution gas inside the first vacuum container is controlled to be a prescribed concentration based on the pressure inside the first vacuum container when the sublimated gas is introduced into the first vacuum container, and for controlling a flow amount of the dilution gas so that a concentration of the sublimated gas in the dilution gas inside the second vacuum container is controlled to be a prescribed concentration based on the pressure inside the second vacuum container when the sublimated gas is introduced into the second vacuum container;

- a lead-out line (L3) that leads out the sublimated gas from the first vacuum container or the second vacuum container into the post process when the concentration of the sublimated gas in the dilution gas reaches the prescribed concentration in a switchable manner; and
- a vacuum pump line (L4) that comprises a vacuum pump (VP) and makes the vacuum containers be in a vacuum state in a switchable manner.

2. The sublimated gas supply system according to claim 1, the system further comprising:

   - a gas heating unit that is arranged in the dilution gas line and controls a temperature of the dilution gas.

3. The sublimated gas supply system according to claim 1, the system further comprising:

   - a concentration measurement unit that is arranged in the lead-out line and measures the concentration of the sublimated gas in the dilution gas in the lead-out line; and

   a monitor unit that monitors the concentration of the sublimated gas in the dilution gas detected by the concentration measurement unit.


**Patentansprüche**

1. Zuführungssystem von sublimiertem Gas zum Zuführen eines aus einem festen Material hergestellten sublimierten Gases zu einer Nachverarbeitung, wobei das System umfasst:

   - einen Behälter (11), der ein festes Material (S1) lagert;
   - eine Behältererwärmungseinheit (12), die den Behälter erwärmt, sodass das sublimierte Gas des festen Materials hergestellt wird;
   - ein Behältermanometer (14), das einen Druck innerhalb des Behälters misst;
   - einen ersten Vakuumbehälter (T1), der so konfiguriert ist, dass das sublimierte Gas aus dem Behälter in einem Zustand eingeleitet wird, in dem ein Druck des sublimierten Gases in einem vorgeschriebenen Unterdruckbereich liegt, wenn der mit dem Behältermanometer gemessene Druck ein gesättigter Dampfdruck des sublimierten Gases ist;
   - ein erstes Manometer (25), das einen Druck innerhalb des ersten Vakuumbehälters misst;
   - einen zweiten Vakuumbehälter (T2), der so konfiguriert ist, dass das sublimierte Gas aus dem Behälter in einem Zustand eingeleitet wird, in dem ein Druck des sublimierten Gases in einem vorgeschriebenen Unterdruckbereich liegt, wenn der mit dem Behältermanometer gemessene Druck ein gesättigter Dampfdruck des sublimierten Gases ist;
   - ein zweites Manometer (27), das einen Druck innerhalb des zweiten Vakuumbehälters misst;
   - eine Ausführungsleitung für sublimiertes Gas (L1), die auf eine umschaltbare Weise das sublimierte Gas aus dem Behälter zu dem ersten Vakuumbehälter oder dem zweiten Vakuumbehälter herausführt;
   - eine Verdünnungsgasleitung (L2), die auf eine umschaltbare Weise Verdünnungsgas in den ersten Vakuumbehälter oder den zweiten Vakuumbehälter einleitet;
   - eine Durchflussmengensteuereinheit (22), die eine Durchflussmenge des Verdünnungsgases so steuert, dass eine Konzentration des sublimierten Gases im Verdünnungsgas innerhalb des ersten Vakuumbehälters gesteuert wird, um eine vorgeschriebene Konzentration zu sein, die auf dem Druck innerhalb des ersten Vakuumbehälters basiert, wenn das sublimierte Gas in den ersten Vakuumbehälter eingeleitet wird, und zum Steuern einer Durchflussmenge des Verdünnungsgases, sodass eine Konzentration des sublimierten Gases im Verdünnungsgas innerhalb des zweiten Vakuumbehälters so gesteuert wird, um eine vorgeschriebene Konzentration zu sein, die auf dem Druck innerhalb des zweiten Vakuumbehälters basiert, wenn das sublimierte Gas in den zweiten Vakuumbehälter eingeleitet wird;
   - eine Ausführungsleitung (L3), die das sublimierte Gas aus dem ersten Vakuumbehälter oder dem zweiten Vakuumbehälter in die Nachverarbeitung herausführt, wenn die Konzentration des sublimierten Gases im Verdünnungsgas die vorgeschriebene Konzentration auf eine umschaltbare Weise erreicht; und
   - eine Vakuumpumpenleitung (L4), die eine Vakuumpumpe (VP) umfasst und den Vakuumbehälter auf eine umschaltbare Weise in einen Vakuumzustand bringt.

2. Zuführungssystem von sublimiertem Gas nach Anspruch 1, wobei das System weiter umfasst:

- eine Gaserwärmungseinheit, die in der Verdünnungsgasleitung angeordnet ist und eine Temperatur des Verdünnungsgases steuert.

**3.** Zuführungssystem von sublimiertem Gas nach Anspruch 1, wobei das System weiter umfasst:

- eine Konzentrationsmesseinheit, die in der Ausführungsleitung angeordnet ist und die Konzentration des sublimierten Gases im Verdünnungsgas in der Ausführungsleitung misst; und

eine Überwachungseinheit, die die Konzentration des sublimierten Gases in dem von der Konzentrationsmesseinheit erfassten Verdünnungsgas überwacht.

**Revendications**

**1.** Système d'alimentation en gaz sublimé pour fournir un gaz sublimé produit à partir d'un matériau solide à un post-traitement, le système comprenant :

- un récipient (11) qui stocke un matériau solide (S1) ;
- une unité de chauffage de récipient (12) qui chauffe le récipient de sorte que soit produit le gaz sublimé du matériau solide ;
- une jauge de pression de récipient (14) qui mesure une pression à l'intérieur du récipient ;
- un premier récipient sous vide (T1) configuré de sorte que le gaz sublimé soit introduit depuis le récipient dans un état où une pression du gaz sublimé se situe dans une plage prescrite de pressions négatives lorsque la pression mesurée avec la jauge de pression du récipient est une pression de vapeur saturée du gaz sublimé ;
- une première jauge de pression (25) qui mesure une pression à l'intérieur du premier récipient sous vide ;
- un second récipient sous vide (T2) configuré de sorte que le gaz sublimé soit introduit depuis le récipient dans un état où une pression du gaz sublimé se situe dans une plage prescrite de pressions négatives lorsque la pression mesurée avec la jauge de pression du récipient est une pression de vapeur saturée du gaz sublimé ;
- une seconde jauge de pression (27) qui mesure une pression à l'intérieur du second récipient sous vide ;
- une conduite d'évacuation de gaz sublimé (L1) qui évacue le gaz sublimé du récipient vers le premier récipient sous vide ou le second récipient sous vide selon un mode commutable ;
- une conduite de gaz de dilution (L2) qui introduit un gaz de dilution dans le premier récipient sous vide ou le second récipient sous vide selon un mode commutable ;

- une unité de commande de quantité d'écoulement (22) qui commande une quantité d'écoulement du gaz de dilution de sorte qu'une concentration du gaz sublimé dans le gaz de dilution à l'intérieur du premier récipient sous vide soit commandée pour être une concentration prescrite sur la base de la pression à l'intérieur du premier récipient sous vide lorsque le gaz sublimé est introduit dans le premier récipient sous vide et pour commander une quantité d'écoulement du gaz de dilution de sorte qu'une concentration du gaz sublimé dans le gaz de dilution à l'intérieur du second récipient sous vide soit commandée pour être une concentration prescrite sur la base de la pression à l'intérieur du second récipient sous vide lorsque le gaz sublimé est introduit dans le second récipient sous vide ;

- une conduite d'évacuation (L3) qui évacue le gaz sublimé du premier récipient sous vide ou du second récipient sous vide dans le post-traitement lorsque la concentration du gaz sublimé dans le gaz de dilution atteint la concentration prescrite selon un mode commutable ; et
- une conduite de pompe à vide (L4) qui comprend une pompe à vide (VP) et fait en sorte que les récipients sous vide soient dans un état de vide selon un mode commutable.

**2.** Système d'alimentation en gaz sublimé selon la revendication 1, le système comprenant en outre :

- une unité de chauffage de gaz qui est agencée dans la conduite de gaz de dilution et commande une température du gaz de dilution.

**3.** Système d'alimentation en gaz sublimé selon la revendication 1, le système comprenant en outre :

- une unité de mesure de concentration qui est agencée dans la conduite d'évacuation et mesure la concentration du gaz sublimé dans le gaz de dilution dans la conduite d'évacuation ; et

- une unité de surveillance qui surveille la concentration du gaz sublimé dans le gaz de dilution détectée par l'unité de mesure de concentration.

Figure 1

Figure 2

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20110158826 A
- US 20040159005 A